(19) Europäisches Patentamt

European Patent Office

Office européen des brevets

(11) **EP 1 641 054 A2**

(12) **EUROPEAN PATENT APPLICATION**

(43) Date of publication:
29.03.2006 Bulletin 2006/13

(51) Int Cl.:
*H01L 51/00* (2006.01)

(21) Application number: 05020105.2

(22) Date of filing: 15.09.2005

(84) Designated Contracting States:
**AT BE BG CH CY CZ DE DK EE ES FI FR GB GR
HU IE IS IT LI LT LU LV MC NL PL PT RO SE SI
SK TR**
Designated Extension States:
**AL BA HR MK YU**

(30) Priority: **24.09.2004 JP 2004277713**

(71) Applicant: **KABUSHIKI KAISHA TOYOTA
JIDOSHOKKI
Kariya-shi,
Aichi-ken (JP)**

(72) Inventors:
• **Yoshida, Mikio**
**K.K. Toyota Jidoshokki**
**Kariya-shi**
**Aichi-ken (JP)**
• **Mori, Kenji**
**K.K. Toyota Jidoshokki**
**Kariya-shi**
**Aichi-ken (JP)**
• **Yamamoto, Ichiro**
**K.K. Toyota Jidoshokki**
**Kariya-shi**
**Aichi-ken (JP)**

(74) Representative: **TBK-Patent**
**Bavariaring 4-6**
**80336 München (DE)**

(54) **Organic EL device**

(57) Provided is an organic EL device, including: a transparent substrate (1) having a front surface and a rear surface; a first electrode (2) layer, an organic layer (3) including a light emitting layer and a second electrode layer (5) that are formed in order on the front surface of the transparent substrate; and a reflective layer (6) formed on the second electrode layer on a side opposite to the organic layer and having light reflectivity for light incident from the second electrode layer, the first electrode layer and the second electrode layer being formed of a transparent material, light being extracted from the rear surface of the transparent substrate.

FIG. 1

**Description**

BACKGROUND OF THE INVENTION

Field of the Invention:

The present invention relates to an organic electroluminescence (EL) device, in particular, a technique of improving a light extraction efficiency of the organic EL device.

Description of the Related Art:

Since an organic EL device can carry out self light emission to obtain a screen of high luminance, a practical application of the organic EL device is widely advanced as a display for a thin and lightweight portable device etc, or an illuminating device. This organic EL device has a structure in which an EL element is formed on a substrate, the EL element comprising: a transparent electrode layer having light permeability, which is made of ITO or the like; a reflective electrode layer having light reflectivity, which is made of A1 or the like; and an organic layer having a light emitting layer interposed between the electrode layers. Light emitted from the light emitting layer is extracted after directly passing through the transparent electrode layer or after being first reflected by the reflective electrode layer and then passing through the transparent electrode layer.

At this time, there is a difference in optical path between the light emitted from the light emitting layer and then directly passing through the transparent electrode layer and the light emitted from the light emitting layer and then reflected by the reflective electrode layer to pass through the transparent electrode layer so that the two lights interfere with each other. Therefore, JP 2002-289358 A proposes a technique of enhancing light extraction efficiency by increasing the thickness of an electron transport layer, a hole transport layer, or other such layers in an organic layer up to such a thickness that induces a light resonance as a result of the light interference.

However, when a layer constituting the organic layer such as the electron transport layer or the hole transport layer is thickened for inducing the light resonance, the distance between the electrode layers increases to increase a drive voltage of an EL element, resulting in larger power consumption of the organic EL device.

Besides, there is a fear that the light extraction efficiency drops since the thickened layer constituting the organic layer lowers the light transmittance of the entire EL element.

SUMMARY OF THE INVENTION

The inventors of the present invention have made extensive studies and developments for solving the above-mentioned problems inherent in the conventional techniques, and as a result, conceived an idea that an effective solution to such a problem is to separate a portion for injecting carriers into the organic layer from a portion for reflecting the light from a light emitting layer, and accomplished the present invention.

An organic EL device according to the present invention includes: a transparent substrate having a front surface and a rear surface; a first electrode layer, an organic layer including a light emitting layer and a second electrode layer that are formed in order on the front surface of the transparent substrate; and a reflective layer formed on the second electrode layer on a side opposite to the organic layer and having light reflectivity for light incident from the second electrode layer, the first electrode layer and the second electrode layer being formed of a transparent material, light being extracted from the rear surface of the transparent substrate.

With such a structure, carriers are injected to an organic layer from a surface of a second electrode layer on an organic layer side, while the light traveling from a light emitting layer to the second electrode side is reflected by the other surface of the second electrode layer opposite to the organic layer. In other words, a portion for injecting carriers to the organic layer is separated from a portion for reflecting the light from the light emitting layer in the organic layer on the second electrode layer side.

BRIEF DESCRIPTION OF THE DRAWINGS

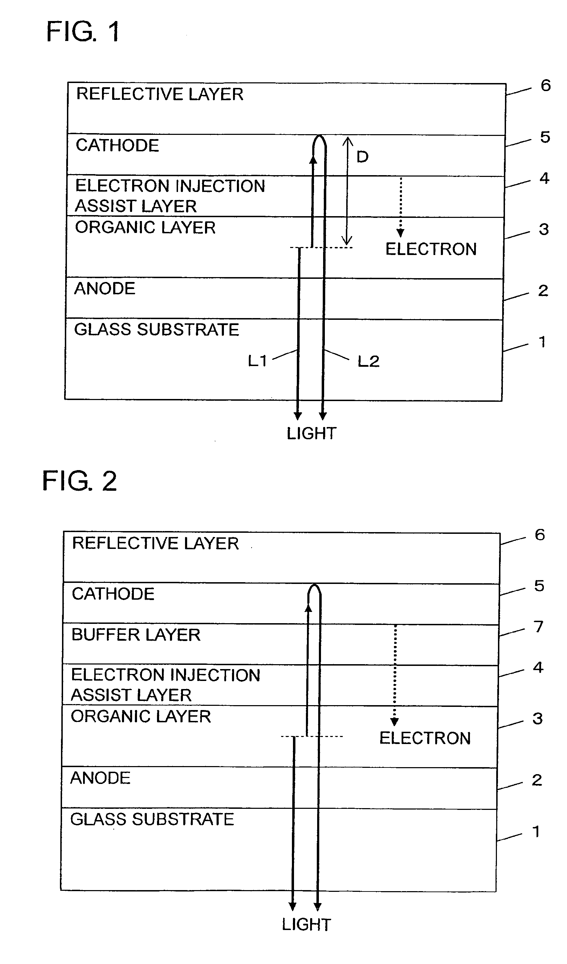

FIGS. 1 to 6 are sectional views showing structures of organic EL devices according to a first embodiment to a sixth embodiment of the present invention, respectively.

DETAILED DESCRIPTION OF THE PREFERRED EMBODIMENTS

Hereinafter, embodiments of the present invention will be described with reference to the accompanying drawings.

First Embodiment:

FIG. 1 is a sectional view showing an organic EL device according to a first embodiment of the present invention. An anode 2 as a first electrode layer is formed on a transparent glass substrate 1, and an organic layer 3 is formed on the anode 2. Further, a cathode 5 as a second electrode layer is formed on the organic layer 3 through an electron injection assist layer 4 as a carrier injection assist layer, and a reflective layer 6 is formed on the cathode 5.

The glass substrate 1 maybemade of a transparent or translucent material which can transmit visible light. Thus, in addition to glass, a resin satisfying such a condition may also be used as a material for the substrate. The anode 2 may have a function as an electrode, and may also be at least transparent or translucent so as to be able to transmit the visible light. Thus, for example, ITO (tin-doped indium oxide) or IZO (zinc-doped indium oxide) may be adopted as a material for the anode 2.

The organic layer 3 may be a single organic layer made of a so-called light emitting material, or a laminate of a light emitting layer made of a light emitting material and at least one of a hole injection assist layer, a hole transport layer, a hole injection transport layer, a hole blocking layer, an electron transport layer, and an electron blocking layer.

The material for the organic layer 3 contains any known organic light emitting material such as $Alq_3$ or DCM. Also, the hole injection assist layer, the hole transport layer, the hole injection transport layer, the hole blocking layer, the electron transport layer, the electron blocking layer, or the like can be formed of a known material as appropriate.

The electron injection assist layer 4 is for assisting the electron injection to the organic layer 3 from the cathode 5, and is formed of such a material that facilitates electron injection to an organic material forming a layer closest to the cathode 5 in the organic layer 3. Examples of such a material include a material selected from the group consisting of an alkali metal element, an alkali earth metal element, a compound of alkali metal or alkali earth metal, and a phthalocyanine derivative, and a mixture of some of those materials. Although depending on the material of the cathode 5 or the layer closest to the cathode 5 in the organic layer 3, the electron injection assist layer 4 is preferably made of Li, LiF, Cs, or the like.

In general, a material for the transparent electrode has a large work function. Hence, when the cathode 5 is formed as a transparent electrode, an energy barrier grows larger upon electron injection from the cathode 5 to the organic layer 3. In this case, the provision of the electron injection assist layer 4 makes the energy barrier small upon the electron injection from the cathode 5 to the organic layer 3, with the result that the drive voltage for the organic EL device can be reduced as compared to the case without the electron injection assist layer 4.

The cathode 5 is made of a conductive material, which is transparent of at least visible light. Examples of such a material include ITO (tin-doped indium oxide), I ZO (zinc-doped indium oxide), IWO (tungsten-doped indium oxide) , ATO (antimony-doped tin oxide), FTO (fluorine-doped tin oxide), AZO (aluminum-doped zinc oxide), and a conductive polymer, which can be used singly or in combination. The transmittance of the cathode 5 for the visible light is preferably 60% or higher, and the material and the film thickness may be determined in combination so as to obtain such a transmittance.

The reflective layer 6 may reflect at least visible light, and preferably has the reflectivity of 70% or higher. Examples of the material forming the reflective layer 6 include A1, Ag, Cr, Mo, an A1 alloy, and an Al/Mo laminate. If formed by using any conductive metal so as to be contacted with the cathode 5, the reflective layer 6 can compensate for the low conductivity of the cathode 5. Hence, the drive voltage of the organic EL device can be made lower. In this case, metal having as high conductivity as possible is desirably used to form the reflective layer 6.

Meanwhile, the reflective layer 6 does not need to function as an electrode, and thus can be formed of an insulator such as a resin. Therefore, a reflective film made of a resin laminate and having the reflectivity higher than metal can be used for the reflective layer 6, which enhances light extraction efficiency.

Those layers may be formed by any known thin film formation method such as vacuum vapor deposition or bonding.

In the organic EL device, a main surface of the glass substrate 1 opposite to the anode 2 is set as a light emission surface. That is, a light L1 traveling to the anode 2 in the light emitted from the light emitting layer passes through the anode 2 and then the glass substrate 1 to be emitted from the device. A light L2 traveling to the cathode 5 passes through the electron injection assist layer 4 and the cathode 5 and is then reflected on the reflective layer 6, and passes through the cathode 5 and the electron injection assist layer 4 and the organic layer 3 again to enter the anode 2. After that, the light L2 passes through the glass substrate 1 to be emitted from the device.

At this time, formed between the light L1 and the light L2 is an optical path difference "2 x D" equivalent to a length twice the distance D from a light emitting position in the light emitting layer to an interface between the cathode 5 and the reflective layer 6. Accordingly, if the optical path difference "2 x D" is set so as to substantially align phases of the light L1 and the light L2, the attenuation resulting from the interference between the light L1 and the light L2 can be reduced to increase the light extraction efficiency.

In order to substantially align the phases of the light L1 and the light L2, the distance from the light emitting position in the light emitting layer to the surface of the reflective layer 6 on the cathode 5 side is set to satisfy the following expression:

$$nL = (2N - 1) \times \lambda/4 \qquad \ldots (1)$$

where: nL represents an optical distance from the light emitting position in the light emitting layer to the surface of the reflective layer 6 on the cathode 5 side, and if the plural layers are arranged between the light emitting layer and the reflective layer 6, the distance nL is equal to the sum of the optical distances of the layers in the thickness direction; N represents a natural number; and $\lambda$ represents a light emission wavelength of the light emitting layer. Here, when there are plural light emission wavelengths, it is possible to use any one of the light emission wavelengths as $\lambda$. Preferably, the wavelength or one of the wavelengths as realize the maximum light emission intensity, or a central wavelength of all the light emission wavelengths may be used as $\lambda$.

Up to now, there have been some proposals for determining the optical distance from the surface of the light emitting layer on the cathode 5 side to the surface of the reflective layer 6 on the cathode 5 side so as to satisfy the expression (1). However, with the conventional technique, since the cathode functions to both inject electrons and reflect light, the thickness of the organic layer (mainly, electron transport layer) between the light emitting layer and the cathode has been adjusted in order to satisfy the expression (1). In general, the organic material, even the electron transport material, is poor in electron transporting property. As a result, the thickened electron transport layer leads to an increase in drive voltage for the entire organic EL device.

On the other hand, in the organic EL device as described in the first embodiment, since a portion for injecting electrons is separated from a portion for reflecting light, the thickness of the cathode 5 can be adjusted to satisfy the expression (1). Even if the thickness of the cathode 5 varies, the portion for injecting electrons to the organic layer 3 is not affected thereby. Therefore, there is no fear that the drive voltage of the organic EL device increases. In the meantime, the optical distance from the surface of the light emitting layer on the cathode 5 side to the surface of the reflective layer 6 on the cathode 5 side can be adjusted, making it possible to improve the light extraction efficiency as well.

The organic EL device according to the first embodiment is manufactured by stacking the anode 2, the organic layer 3, the electron injection assist layer 4, the cathode 5, and the reflective layer 6 in order on the surface of the glass substrate 1 by using any known thin film formation method such as vacuum vapor deposition.

Further, a protective layer made of silicon nitride, silicon oxynitride, silicon oxide, or the like is optionally formed through plasma CVD, coating, bonding, or the like, on the reflective layer 6.

Second Embodiment:

FIG. 2 is a sectional view of an organic EL device according to a second embodiment of the present invention. This organic EL device is the same as the device of the first embodiment as shown in FIG. 1 except that a buffer layer 7 is interposed between the electron injection assist layer 4 and the cathode 5.

The buffer layer 7 is effectively used for when electrons are not efficiently injected from the cathode 5 to the electron injection assist layer 4 in the first embodiment. Examples of the material for the buffer layer 7 include a material selected from the group consisting of: Al, Ag, Mg, and In, and a mixture of some of those materials.

The provision of the buffer layer 7 suppresses an increase in drive voltage of the organic EL device even if the cathode 5 is formed of a transparent, conductive material.

The buffer layer 7 has to transmit at least visible light, and is thus desirably formed into the thickness of 50 nm or less, more preferably 20 nm or less.

After the formation of the buffer layer 7 on the surface of the electron injection assist layer 4 by any known thin film formation method such as vacuum vapor deposition, the cathode 5 and the reflective layer 6 may be sequentially formed on the surface of the buffer layer 7. The buffer layer 7 also functions to alleviate the influence on the organic layer 3 such as heat generated in a subsequent step of forming the cathode 5 and the reflective layer 6.

Third Embodiment:

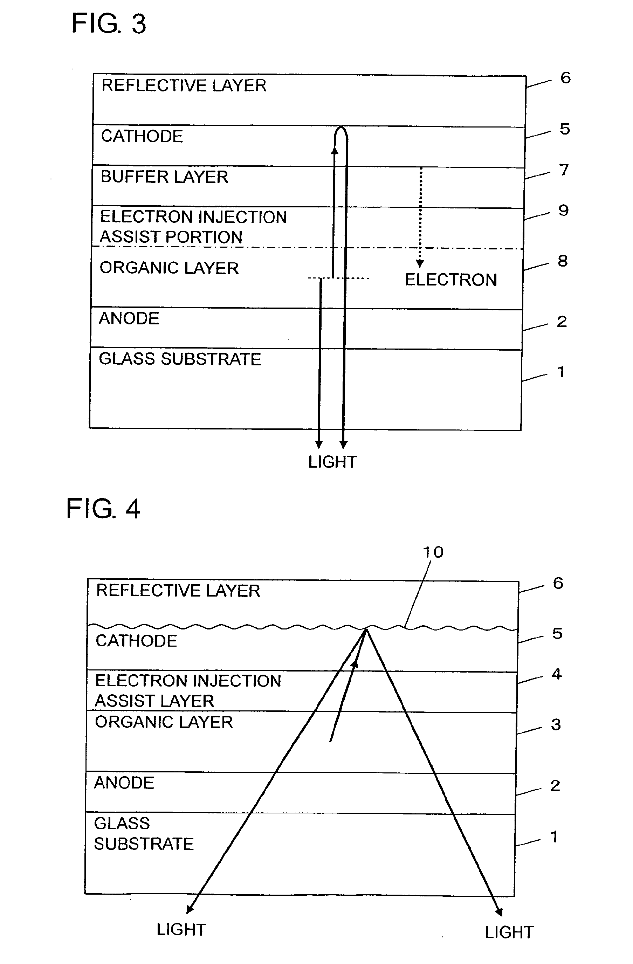

FIG. 3 is a sectional view of an organic EL device according to a third embodiment of the present invention. This organic EL device is the same as the device of the second embodiment as shown in FIG. 2 except that an organic layer 8 including an electron injection assist portion 9 is formed on the anode 2 instead of forming the organic layer 3 and the electron injection assist layer 4.

The electron injection assist portion 9 is formed through vapor co deposition of an organic material forming a layer closest to the cathode 5 in the organic layer 8 with a material selected from the group consisting of: an alkali metal element; an alkali earth metal element; a compound of alkali metal or alkali earth metal; andaphthalocyaninederivative (forexample, Li or Cs) . Theelectron injection assist portion 9 assists the electron injection from the cathode 5 to the organic layer 8 as the electron injection assist layer 4.

Fourth Embodiment:

FIG. 4 is a sectional view of an organic EL device according to a fourth embodiment of the present invention. This organic EL device is the same as the device of the first embodiment as shown in FIG. 1 except that a light scattering means 10 is provided between the cathode 5 and the reflective layer 6.

The light scattering means 10 is obtained by making the surface of the cathode 5 uneven through etching or surface treatment based on sandblasting, and forming the reflective layer 6 on the uneven surface. In this case, the light scattering means 10 is formed on the surface of the reflective layer 6 on the cathode 5 side. As discussed in the first embodiment, electrons are injected to the organic layer 3 from an interface between the electron injection assist layer 4 and the cathode 5, while light is reflected on an interface between the cathode 5 and the reflective layer 6. Hence, the cathode 5 can be formed with a larger thickness without adversely affecting the drive voltage of the organic EL device. As a result, the surface of the cathode 5 can be made uneven.

The light scattering means 10 can be provided between the cathode 5 and the reflective layer 6. This light scattering means may be, for example, an insulator such as a light scattering sheet containing fine particles such as beads in a resin binder. As mentioned above, since the reflective layer 6 does not need to have conductivity, such light scattering means 10 can be provided between the cathode 5 and the reflective layer 6.

Owing to the provision of the light scattering means 10, the light emitted from the organic layer 3 and then traveling to the cathode 5 passes through the electron injection assist layer 4 and the cathode 5, and is then diffused by the light scattering means 10 and reflected by the reflective layer 6. After that, the light passes through the cathode 5, the electron injection assist layer 4, and the organic layer 3 again to enter the anode 2, and then passes through the glass substrate 1 to be emitted from the device. Therefore, the light, which would be otherwise totally reflected on an interface between the glass substrate 1 and the atmosphere as the light exit surface, changes its traveling direction at the light scattering means 10, and can be extracted from the light exit surface to improve the light extraction efficiency of the organic EL device.

In addition, since the outside light incident from the glass substrate 1 is diffused as well by the light scattering means 10, a glare of the outside light can be reduced.

Similarly, the light scattering means 10 may be provided to the organic EL device of the second or third embodiment of the present invention.

Fifth Embodiment:

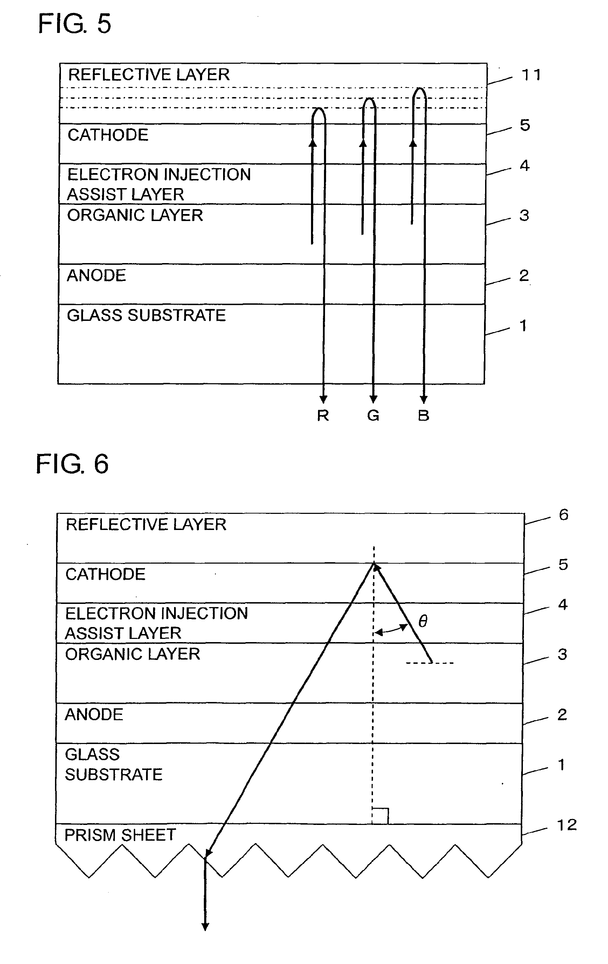

FIG. 5 is a sectional view of an organic EL device according to a fifth embodiment of the present invention. This organic EL device is the same as the device of the first embodiment as shown in FIG. 1 except that plural light beams of different wavelengths are emitted from the light emitting layer, and a reflective layer 11 made of a multilayer film is formed on the cathode 5 in place of the reflective layer 6 made of metal.

For example, when the light emitting layer emits light beams in three colors, R, G, and B, the thickness of the cathode 5 and the thickness of each layer in the multilayer film forming the reflective layer 11 are determined so as to attain an optical path difference that substantially aligns phases of light traveling to the anode 2 and light traveling to the cathode 5 and returning therefrom, for each of the light beams in R, G, and B. The formation of the reflective layer 11 as the multilayer film makes it possible to set the optical path difference that enables substantially aligned phases as for the light beams in R, G, and B.

As a result, in the organic EL device emitting light beams in multiple colors, such as a white EL device, it is possible to achieve substantially aligned phases for each color to thereby improve the light extraction efficiency of the entire organic EL device.

Similarly, the optical path difference can also be set so as to attenuate a light beam of a specific color due to light interference.

Sixth Embodiment:

FIG. 6 is a sectional view of an organic EL device according to a sixth embodiment of the present invention.

This organic EL device is the same as the device of the first embodiment as shown in FIG. 1 except that a prism sheet 12 as a light collecting member is provided on the light exit surface of the glass substrate 1.

The prism sheet 12 is such that microprisms shaped in triangle in section are arranged on a plane one after another. Through the provision of the prism sheet 12 on the glass substrate 1, the light emitted from the glass substrate 1 is refracted by facets forming a prism and thus focused in a predetermined direction.

Provided that θ represents the angle between the traveling direction of light to be focused in a normal direction of the glass substrate 1 by means of the prism sheet 12, and the normal direction of the glass substrate 1, the thickness of the cathode 5 is desirably adjusted to satisfy the following expression (2):

$$nL \times \cos\theta = (2N - 1) \times \lambda/4 \qquad \ldots (2)$$

where nL represents an optical distance from a light emittingposition in the light emitting layer to the surface of the reflective layer 6 on the cathode 5 side, and if the plural layers are arranged between the light emitting layer and the reflective layer 6, the distance nL is equal to the sum of the optical distances of each layer in the thickness direction; N represents a natural number; and λ represents a light emission wavelength of the light emitting layer. Here, when there are plural light emission wavelengths, it is possible to use any one of the light emission wavelengths as λ. Preferably, the wavelength or one of the wavelengths as realize the maximum light emission intensity, or a central wavelength of all the light emission wavelengths may be used as λ.

When the thickness of the cathode 5 is set to satisfy the numerical expression (2), phases of light beams traveling at the angle of θ to the normal of the glass substrate 1 can be aligned. The light traveling at the angle of θ to the normal of the glass substrate 1 is focused into the normal direction of the glass substrate 1 by means of the prism sheet 12, whereby the finally attained extraction efficiency for the light traveling in the normal direction of the glass substrate 1 is improved. As a result, the front brightness can be enhanced without increasing the drive voltage.

Note that in the first to sixth embodiments, the anode 2 and the cathode 5 are formed as the first electrode layer and the second electrode layer, respectively. However, the cathode and the anode may be conversely formed as the first electrode layer and the second electrode layer, respectively. In this case, aholeinjectionassist layer for assisting hole injection to the organic layer is preferably formed between the light emitting layer and the second electrode layer, or a light emitting layer including a hole injection assist portion is preferably formed.

Further, the electron injection assist layer 4, the electron injection assist portion 9, and the buffer layer 7 are not necessarily required, and may be omitted when the organic layer 3 on the cathode side and the cathode 5 are made of such material that enable efficient electron injection from the cathode 5 to the organic layer 3.

In the second to fifth embodiments as well, the light collecting member may be provided on the light exit surface of the glass substrate 1. At this time, when the thickness of the cathode 5 is adjusted to satisfy the expression (2) as in the sixth embodiment, the brightness in the normal direction of the glass substrate 1 is increased.

Concrete Example:

An anode was formed on a transparent glass substrate of 0.5 mm in thickness with the thickness of 150 nm using ITO through sputtering. After that, the substrate was washed with an alkali as a substrate washing process prior to the vapor deposition of an organic layer, followed by washing with pure water. Then, the substrate was dried and cleaned with UV-ozone.

The substrate was transferred into a chamber for vacuum evaporator where α-NPD was evaporated from a molybdenum boat and deposited into a 30 nm-thick film on the surface of the anode as a hole transport layer at a deposition rate of 0.1 nm/s and the degree of vacuum of about $5.0 \times 10^{-5}$ Pa.

Further, $Alq_3$ (99%) and C545T (1%) were co deposited and deposited into a 40 nm-thick film on the hole transport layer as an organic layer containing a light emitting material at a deposition rate of 0.1 nm/s and the degree of vacuum of about $5.0 \times 10^{-5}$ Pa.

Then, $Alq_3$ was evaporated from a molybdenum boat and deposited into a 30 nm-thick film on the organic layer as an electron transport layer at a deposition rate of 0.1 nm/s and the degree of vacuum of about $5.0 \times 10^{-5}$ Pa.

Thereafter, $Li_2O$ (lithium oxide) was evaporated froman alumina crucible and deposited into a 1 nm-thick film on the electron transport layer as an electron injection assist layer at a deposition rate of 0.03 nm/s and the degree of vacuum of about $5.0 \times 10^{-5}$ Pa.

Further, a cathode was formed on the electron injection assist layer with the thickness of 50 nm using ITO through sputtering.

Then, aluminum was evaporated from a tungsten boat and deposited into a 150 nm-thick film on the cathode as a reflective layer at a deposition rate of 1 nm/s and the degree of vacuum of about $5.0 \times 10^{-5}$ Pa to complete an organic EL device.

Comparative Example 1:

An organic EL device of Comparative Example 1 was produced similar to the above-described Concrete Example, except that the thickness of the electron transport layer made of $Alq_3$ was set to 40 nm, and a 150 nm-thick aluminum layer was formed as a cathode/reflective layer in place of the cathode made of ITO and the reflective layer made of aluminum.

Comparative Example 2:

An organic EL device of Comparative Example 2 was produced similar to the above-described Concrete Example, except that the thickness of the electron transport layer made of $Alq_3$ was set to 80 nm, and a 150 nm-thick aluminum layer was formed as a cathode/reflective layer in place of the cathode and the reflective layer so as to substantially align a phase of the light directly exiting the device without being reflected by the cathode/reflective layer with a phase of the light exiting the device after being reflected by the cathode/reflective layer.
Power consumption and life time of the thus-completed organic EL devices of Concrete Example, Comparative Examples 1 and 2 were measured for the same front brightness. As a result, provided that the power consumption and life time of Comparative Example 1 are defined as 100, respectively, the power consumption of Comparative Example 2 is about 90 and the life time thereof is about 110, while the power consumption of Concrete Example is about 70 and the life time thereof is about 150. The results suggest that in the organic EL device of Concrete Example, since the light extraction efficiency increases, the light emission brightness of the organic EL device can be lowered for the same front brightness, making it possible to lower a requisite level of voltage and current and significantly save the power consumption. In addition, an amount of supplied current is reduced, whereby loads on the organic EL device such as generated heat are reduced, with the result that the life time lengthens. Note that in Comparative Example 2, a phase of light directly exiting the device was aligned with a phase of light exiting the device after being reflected by the cathode/reflective layer, whereby the light extraction efficiency was improved. However, the thickness of the electron transport layer was made as large as 80 nm. Supposedly, this would lead to an increase in drive voltage and hinder the reduction of the power consumption to a satisfactory level.
Also, the organic EL devices of Concrete Example, Comparative Examples 1 and 2 were combined with a light diffusing film and a brightness enhancement film, and measured for the power consumption and the life time as well in case of the uniform front brightness. Provided that the power consumption and the life time of Comparative Example 1 are defined as 100, respectively, the power consumption of Comparative Example 2 is about 80 and the life time is about 120. In contrast, the power consumption of Concrete Example is about 60 and the life time thereof is about 170.
According to the present invention, the carrier injection to the organic layer and the reflection of light travelling to the second electrode from the light emitting layer are effected in different portions. That is, the portion involved in the carrier injection to the organic layer is separated from a portion involved in reflection of light from the light emitting layer.
Provided is an organic EL device, including: a transparent substrate having a front surface and a rear surface; a first electrode layer, an organic layer including a light emitting layer and a second electrode layer that are formed in order on the front surface of the transparent substrate; and a reflective layer formed on the second electrode layer on a side opposite to the organic layer and having light reflectivity for light incident from the second electrode layer, the first electrode layer and the second electrode layer being formed of a transparent material, light being extracted from the rear surface of the transparent substrate.

**Claims**

1.    An organic EL device, comprising:

        a transparent substrate having a front surface and a rear surface;
        a first electrode layer, an organic layer including a light emitting layer, and a second electrode layer that are formed in order on the front surface of the transparent substrate; and
        a reflective layer formed on the second electrode layer on a side opposite to the organic layer and having light reflectivity for light incident from the second electrode layer,
        the first electrode layer and the second electrode layer being formed of a transparent material, light being extracted from the rear surface of the transparent substrate.

2.    An organic EL device according to claim 1, wherein the first electrode layer forms an anode layer, and the second electrode layer forms a cathode layer.

3. An organic EL device according to claim 1, wherein the transparent material forming the second electrode layer includes at least one selected from the group consisting of ITO, IZO, IWO, ATO, FTO, AZO, and a conductive polymer.

4. An organic EL device according to claim 3, wherein the transparent material forming the second electrode layer is a mixture of two or more materials selected from the group consisting of ITO, IZO, IWO, ATO, FTO, AZO, and a conductive polymer.

5. An organic EL device according to claim 1, further comprising a carrier injection assist layer interposed between the second electrode layer and the organic layer for assisting carrier injection to the organic layer.

6. An organic EL device according to claim 5, wherein the carrier injection assist layer is made of at least one material selected from the group consisting of an alkali metal element, an alkali earth metal element, an alkali metal compound, an alkali earth metal compound, and a phthalocyanine derivative.

7. An organic EL device according to claim 6, wherein the carrier injection assist layer is made of a mixture of two or more materials selected from the group consisting of an alkali metal element, an alkali earth metal element, an alkali metal compound, an alkali earth metal compound, and a phthalocyanine derivative.

8. An organic EL device according to claim 5, further comprising a buffer layer interposed between the second electrode layer and the carrier injection assist layer, the buffer layer being transparent.

9. An organic EL device according to claim 8, wherein the buffer layer is made of at least one material selected from the group consisting of aluminum, silver, magnesium and indium.

10. An organic EL device according to claim 9, wherein the buffer layer is made of a mixture of two or more materials selected from the group consisting of aluminum, silver, magnesium and indium.

11. An organic EL device according to claim 8, wherein the buffer layer has the thickness of 50 nm or smaller.

12. An organic EL device according to claim 1, wherein the reflective layer is made of metal having light reflectivity and conductivity.

13. An organic EL device according to claim 1, further comprising light scattering means interposed between the second electrode layer and the reflective layer.

14. An organic EL device according to claim 12, wherein the reflective layer comprises a multilayer film.

15. An organic EL device according to claim 14, wherein the light emitting layer emits a plurality of light beams of different wavelengths, and the thickness of the second electrode layer and the thickness of each layer of the multilayer film forming the reflective layer are set so as to attain an optical path difference that substantially aligns a phase of light traveling to the first electrode layer from the light emitting layer with a phase of light traveling to the second electrode layer and reflected thereby for each of the plurality of light beams.

16. An organic EL device according to claim 1, wherein a condition represented by the following expression (1) is satisfied:

$$nL = (2N - 1) \times \lambda/4 \qquad \dots (1)$$

where nL represents an optical distance from a light emitting position in the light emitting layer to a surface of the reflective layer on the second electrode layer side, N represents a natural number, and $\lambda$ represents one of a light emission wavelength of the light emitting layer, a wavelength that maximizes a light emission intensity when there are plural light emission wavelengths, and a central wavelength of all the light emission wavelengths when there are plural light emission wavelengths.

17. An organic EL device according to claim 1, further comprising a light collecting member arranged on the rear surface of the transparent substrate,
a condition represented by the following expression (2) being satisfied:

$$nL \times \cos\theta = (2N - 1) \times \lambda/4 \qquad \dots (2)$$

where nL represents an optical distance in a normal direction of the transparent substrate from a light emitting position in the light emitting layer to a surface of the reflective layer on the second electrode layer side, θ represents an angle between the normal direction of the transparent substrate and a traveling direction of light to be focused in the normal direction of the transparent substrate by means of the light collecting member, N represents a natural number, and λ represents one of a light emission wavelength of the light emitting layer, a wavelength that maximizes a light emission intensity when there are plural light emission wavelengths, and a central wavelength of all the light emission wavelengths when there are plural light emission wavelengths.

18. An organic EL device according to claim 17, wherein the light collecting member comprises a prism sheet.

## FIG. 1

| | |
|---|---|
| REFLECTIVE LAYER | 6 |
| CATHODE | 5 |
| ELECTRON INJECTION ASSIST LAYER | 4 |
| ORGANIC LAYER | 3 |
| ANODE | 2 |
| GLASS SUBSTRATE | 1 |

D

ELECTRON

L1    L2

LIGHT

## FIG. 2

| | |
|---|---|
| REFLECTIVE LAYER | 6 |
| CATHODE | 5 |
| BUFFER LAYER | 7 |
| ELECTRON INJECTION ASSIST LAYER | 4 |
| ORGANIC LAYER | 3 |
| ANODE | 2 |
| GLASS SUBSTRATE | 1 |

ELECTRON

LIGHT

## FIG. 3

| | |
|---|---|
| REFLECTIVE LAYER | 6 |
| CATHODE | 5 |
| BUFFER LAYER | 7 |
| ELECTRON INJECTION ASSIST PORTION | 9 |
| ORGANIC LAYER | 8 |
| ANODE | 2 |
| GLASS SUBSTRATE | 1 |

ELECTRON

LIGHT

## FIG. 4

10

| | |
|---|---|
| REFLECTIVE LAYER | 6 |
| CATHODE | 5 |
| ELECTRON INJECTION ASSIST LAYER | 4 |
| ORGANIC LAYER | 3 |
| ANODE | 2 |
| GLASS SUBSTRATE | 1 |

LIGHT          LIGHT

## FIG. 5

| | |
|---|---|
| REFLECTIVE LAYER | 11 |
| CATHODE | 5 |
| ELECTRON INJECTION ASSIST LAYER | 4 |
| ORGANIC LAYER | 3 |
| ANODE | 2 |
| GLASS SUBSTRATE | 1 |

R   G   B

## FIG. 6

| | |
|---|---|
| REFLECTIVE LAYER | 6 |
| CATHODE | 5 |
| ELECTRON INJECTION ASSIST LAYER | 4 |
| ORGANIC LAYER | 3 |
| ANODE | 2 |
| GLASS SUBSTRATE | 1 |
| PRISM SHEET | 12 |

$\theta$